# EUROPEAN PATENT SPECIFICATION

(11) **EP 3 674 127 B1**
(45) Date of publication and mention of the grant of the patent: **01.10.2025**
(21) Application number: 18383008.2
(22) Date of filing: 28.12.2018
(51) Int. Cl.: B60L 3/00, G01R 31/327, H01H 47/00, G01R 31/00

(54) **SYSTEM FOR DIAGNOSING THE STATE OF A CONTACTOR OF AN ELECTRIC VEHICLE WORKING IN A VOLTAGE RANGE HIGHER THAN THE SYSTEM FOR DIAGNOSING**
SYSTEM ZUR DIAGNOSE DES ZUSTANDS EINES SCHÜTZES EINES ELEKTROFAHRZEUGS, DAS IN EINEM SPANNUNGSBEREICH ARBEITET, DER HÖHER ALS DAS DIAGNOSESYSTEM IST
SYSTÈME DE DIAGNOSTIC DE L'ÉTAT D'UN CONTACTEUR DE VÉHICULE ÉLECTRIQUE TRAVAILLANT DANS UNE GAMME DE TENSION SUPÉRIEURE AU SYSTÈME DE DIAGNOSTIC

(43) Date of publication of application: 01.07.2020
(73) Proprietor: Fico Triad, S.A., 08028 Barcelona (ES)
(72) Inventor: GAIG FONT, Miquel, 08232 Viladecavalls (Barcelona) (ES); SALA MASIP, Enric, 08232 Viladecavalls (Barcelona) (ES); Marsal Roig, Marc, 08232 Viladecavalls (Barcelona) (ES)
(74) Representative: Elzaburu S.L.P.

(56) References cited:
- EP-A1- 2 624 442
- JP-A- 2006 282 093
- JP-A- H02 192 316
- US-A1- 2011 298 470
- US-A1- 2013 337 294
- US-A1- 2014 028 322
- US-A1- 2015 266 388

## Description

### Field of the invention

The invention is related to a system and method diagnosing the state of a contactor in electric vehicles. More particularly, to a battery circuit for an electric vehicle (EV) or a hybrid electric vehicle (HEV) that includes circuit components for determining the state of the contacts working in a voltage range higher than the diagnosis.

### Background of the invention

In high voltage systems, power contactors are commonly used to guarantee galvanic isolation between power devices. For instance, in a Cut Off Box known in the state of the art, there are two main contactors that isolate the battery from the charger or from the load. During a drive cycle, the contactors close to electrically couple the battery with other areas of the powertrain. When the drive cycle is complete, the contactors open to, for example, protect the relatively high voltage from the battery or for isolating the battery to the rest of the circuitry when there is an isolation resistance fault. If the contactor is welded closed, the contactor does not open and the circuit may remain closed.

A controller is configured to open and close the contactors of the contactor assembly. The contactors are typically closed during a drive cycle. Closing the contactors permits electrical power to circulate to and from the battery. At the conclusion of the drive cycle, when the powertrain is not operating, the contactors are opened.

The afored metioned systems have the drawback that the contact could have an state different than the required by the controller.

JP200682093A discloses a system and method for detecting presence or absence of closed circuit failure of a relay in the path between a vehicle battery and a motor driven compressor based on the passing electric current value. The passing current detector comprises an optocoupler.

### Summary of the invention

It is an object of the invention a contactor diagnosis system of an electric vehicle comprising:
- a contactor movable between a closed and an open state,
- means for detecting a current passing through the means, located in parallel to the contactor and operatively connected to the power source, and
- a controller operatively connected to the contactor and to the means for detecting a current passing through it, the controller being configured for:
   ∘ communicating with the contactor and registering in the controller a theoretic open or close state of the contactor,
   ∘ receiving a signal from the means for detecting a current passing through it:
      ▪ if current is passing through the means, the received signal is that the contactor is open, and
      ▪ if current is not passing through the means, the received signal is that the contactor is closed.
   ∘ comparing the theoretic state of the contactor with the state of the contactor received from the means for detecting a current passing through it.

It is also an object of the present invention a method for detecting a contactor state of an electric vehicle, comprising the following steps:
- communicating a controller with a contactor and registering in the controller a theoretic open or close state of the contactor,
- receiving a signal in the controller from a means for detecting a current passing through the means:
   ▪ if current is passing through the means, the signal received is that the contactor is open, and
   ▪ if current is not passing through the means, the signal received is that the contactor is closed.
- comparing in the controller the theoretic state of the contactor with the state of the contactor received from the means for detecting a current passing through it.

It is understood in the application by communicating the controller and the contactor as the process by which signals comprising information and/or actions may be exchanged between the controller and the contactor, at least from the controller to the contactor and, preferably, in both directions, either directly between both elements, or indirectly, through at least a second controller or an intermediate module interposed between the controller and the contactor.

Thus, said referred communication encompasses the action of the controller sending a signal to the contactor to change its state to an open or a closed state. Additionally the controller registers said state as being the theoretic state of the contactor.

Equally, said communication also encompasses an alternative that is receiving a signal in the controller with the state of the contactor and to register it in the controller as the theoretic state.

As previously stated, in different embodiments, the controller may be a single element or a plurality of elements that receive different signals so that finally the controller of the diagnosis system makes the afored mentioned comparison. Thus, the expression communication also encompasses the alternative of the controller of the diagnosing system communicating with the contactor indirectly by the controller receiving a signal with the state of the contactor from other controller that in turn sends a first signal to the contactor to change its state to an open or a closed state and a second signal to the controller of the diagnosys system with the state of the contactor.

Therefore, the contactor may be configured for being commanded by the controller of the diagnosis system or by another controller.

In an embodiment, the system comprises a power source operatively connected to the contactor and to the means for detecting a current passing through it.

In one embodiment, the power source is the battery of the electric vehicle and/or the charger of the vehicle, On Board Charger OBC.

One of the advantages of the system and the method of the invention is that the detection is based in current flow rather than voltage measurements.

According to the invention, the means for knowing if there is current passing or not is an optocoupler. Optocoupler systems are commonly used to avoid interference between circuits of different voltage ranges. As the detection is based in current flow and optocouplers are used, this embodiment avoids interference with other cirtuits and also reduces the costs of the system.

Specifically, if contactors are open and optocouplers are enabled, current should flow through them. While current is flowing through them, the signal received by the controller from the means or, in the mentioned embodiment, from the optocoupler, would be "1", therefore the contactor is in an open state.

If contactors are closed, current will not flow through optocouplers, as contactor path has lower impedance, and therefore the signal received by the controller from the means, or in the mentioned embodiment, from the optocoupler, would be "0", thus, the contactor is in a closed state.

According the above embodiment, the controller is configured to manage the system to make the diagnosis of the contactor state by communicating with:
- the contactor, and
- the optocoupler or another means for detecting a current passing through it.

Once the controller has made the before mentioned comparison it may be configured to:
- send a signal of the state of the contactor, or
- if there is discrepancy between the theoretic state of the contactor and the state received from the means, to send a signal according to this discrepancy, for instance, to operate some security element by isolating the battery opening other switches or sending a signal to the system controlling charges or sending a signal to the driver, etc.

Apart from the diagnosis state of the contactor, the same system could be used to check that relays have been closed properly during the Precharge sequence. The present system can be able to know the state of any contactor when the relationship between circuit and diagnostic voltages is different.

### Description of the figures

To complete the description and in order to provide for a better understanding of the invention, drawings are provided. Said drawings form an integral part of the description and illustrate a preferred embodiment of the invention. The drawings comprise the following figures.
Figure 1 shows an embodiment of the diagnosis system of the invention.
Figure 2 shows another embodiment of the diagnosis system of the invention.

### Detailed description of the invention

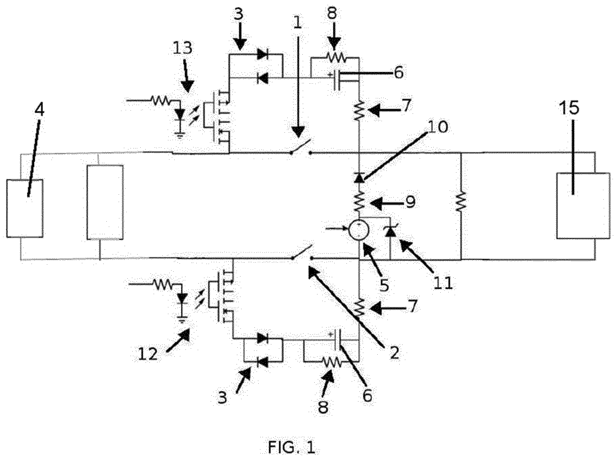

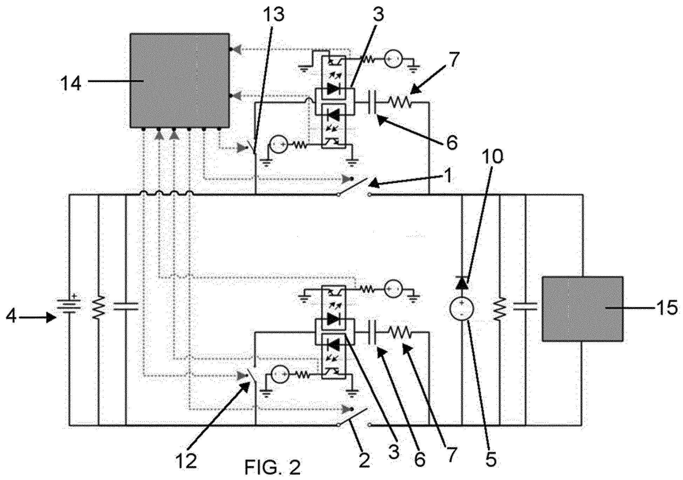

Figures 1 and 2 disclose an embodiment of the system object of the invention comprising:
- a power source, specifically the system of the embodiment can be fed by a battery (4), or by an on board charger (15) or by an additional power source (5) operatively connected to the contactor (1, 2) and to the means (3) for detecting a current passing through said means. The additional power source (5) may be controlled by a controller (14),
- two contactors (1, 2) operatively connected to a power source. In the embodiment shown in figure 1, a first contactor (1) is associated with a positive terminal of the battery (4). The second contactor (2) is associated with a negative terminal of the battery (4). The controller (14) commands the first contactor (1) and the second contactor (2) to open and close states.
- means (3) for detecting a current passing through said means, located in parallel to the contactors (1, 2). In the shown embodiment, said means are two optocouplers. In the disclosed embodiment, each optocouplers comprises two inverted diodes, LS1 and LS2 associated with the negative terminal and HS1 and HS2 (3) associated with the positive terminal. The two inverted diodes avoid problems with different currents from both sides of the system allowing the optocouplers to work with currents from both sides.
- a controller (14) operatively connected to the possible additional power source (5), the contactors (1, 2) and the optocouplers (3) and configured for:
   ∘ changing the additional power source (5) to an on state, in case the additional power source (5) is necesary to be operated,
   ∘ changing the state of the contactor (1, 2) by the controller (14),
   ∘ registering the theoretic state of the contactor (1, 2) in the controller (14),
   ∘ put in parallel to the contactor (1, 2) the diagnosis circuitry, i.e., the means for detecting a current passing through said means, by, for instance, closing switches (12, 13). In the shown embodiments said switches (12, 13) are optomosfets,
   ∘ receiving a signal from the optocoupler (3):
      ▪ if current is passing through the octocopuler (3), the contactor (1, 2) is open, and
      ▪ if current is not passing through the octocopuler (3), the contactor (1, 2) is closed,
   ∘ comparing the real state of the contactor (1, 2) with the theoretic state, being the real state the state reflected by the means for detecting a current passing through said it and the theoretic state the state to what the contactors (1, 2) have been changed,
   ∘ emitting a signal of the state of the contactors (1, 2) provided by the optocoupler (3) and/or emitting a signal when there is a discrepancy between theoretic an real states,
   ∘ isolating the diagnosis circuitry from the contactors (1, 2), by for instance, opening switches (12, 13),
   ∘ changing the additional power source state (5) to an off state, if it has been previously set on.

According to the above, the controller (14) is configured to manage the system to make the diagnosis of the contactor (1, 2) state by controlling the following items:
- contactors (1, 2),
- the switches (12, 13) of the two diagnosis circuitry, i.e., of the two optocouplers (3),
- receiving data from the optocouplers (3) and, eventually, compare the data with the theoretic state of the contactors (1, 2),
- emitting contactor (1, 2) state signals and/or emitting a signal of discrepancy between theoretic an real state.

Specifically, if contactors (1, 2) are opened and optocouplers (3) are enabled, current should flow through them until a condenser (6) is fully charged.

Switches (12, 13) of the two diagnosis circuitry has the additional advantage of providing isolation to contactors (1, 2) poles and the switches (12, 13) isolate the diagnosis circuitry after the diagnosis has been performed.

The circuit system could use the voltage from the battery (4) for functioning or from the power source by the charger (15), and thanks to the additional power source (5) operatively connected to the contactors (1, 2), the system is able to detect the contactor (1, 2) state under the absence or presence of battery (4) and/or the charger (15).

Therefore, the detection could be done in the following conditions:
- Battery (4) connected and charger (15) disconnected.
- Charger (15) connected and battery (4) disconnected.
- Both battery and charger (4, 15) disconnected.

In the shown embodiment, the system comprises as additional power source (5), a low voltage injection, specifically a flyback that injects 20V in order to do the diagnostic in case that there is no or enough voltage in the system at that moment.

One of the adavantages of the system shown in the embodiment is that it works independently of the battery (4) and the charger (15) voltage because it has its own voltage injection. As the battery (4) and the charger (15) have its own contactors, there is a situation where the system has no outside voltage at contactor's (1, 2) poles, so it is needed an internal additional power source (5) to perform the detection.

In the embodiment shown in the figures, the first contactor (1) is associated with the positive terminal of the additional power source (5) and the second contactor (2) is associated with a negative terminal of the additional power source (5).

Additionally, the embodiment shown in the figures comprises the following elements:
- Resistor, Rw (7), it limits the current through the optocouplers (3) diode.
- Capacitor, Cw (6), it limits the power dissipation on Rw (7) and avoids constant power dissipation in the event of failure of the optocoupler (3).
- Resistor RdschgC (8): needed to discharge the Cw capacitors (6).
- Resistor Rlimit (9): Limits the current out of the flyback DC-DC Converter. Additionally, although the battery (4) is in operation, the additional power source (5) is used, but as it provides only 20V, there has to be a tension differential until the voltage of the battery (4) is reached.
- Diode, DBlocking (10): Blocks the battery or OBC voltage.
- Diode Dz (11): In the event of no load provides a regulated voltage.

## Claims

1. **System** for diagnosing the state of a contactor of an electric vehicle working in a voltage range higher than the system for diagnosing, the system comprising:
- a contactor (1, 2) movable between a closed and an open state,
- means (3) for detecting a current comprising an optocoupler to know if there is current passing or not through the means (3), the means (3) connected in parallel to the contactor (1, 2) path, wherein the contactor (1, 2) path has lower impedance than the means (3) path, and
- a controller (14) operatively connected to the contactor (1, 2) and to the means (3) for detecting a current, the controller (14) being configured for:
∘ communicating with the contactor (1, 2) and registering in the controller (14) a theoretic open or close state of the contactor (1, 2) by changing the contactor (1, 2) state and to register in the controller (14) said state as theoretic state or by receiving a signal with the state of the contactor (1, 2) and to register it in the controller (14) as the theoretic state,
∘ receiving a signal from the means (3) for detecting a current :
▪ if current is passing through the optocoupler, the received signal is that the contactor (1, 2) is open, and
▪ if current is not passing through the optocoupler, the received signal is that the contactor (1, 2) is closed,
∘ comparing the theoretic state of the contactor (1, 2) with the state of the contactor (1, 2) received from the means (3) for detecting a current,
- a resistor (7) configured to limit the current through the optocoupler,
the system **characterised in that** it comprises:
- a capacitor (6) configured such that if the contactor (1, 2) is opened and the optocoupler is enabled, current flows through it until the capacitor (6) is fully charged, the capacitor (6) configured to limit the power dissipation on the resistor (7).

2. System for diagnosing the state of a contactor of an electric vehicle working in a voltage range higher than the system for diagnosing, according to claim 1, wherein it comprises a power source operatively connected to the contactor (1, 2) and to the means (3) for detecting a current.

3. System for diagnosing the state of a contactor of an electric vehicle working in a voltage range higher than the system for diagnosing, according to claim 2, wherein the power source is the battery (4) of the electric vehicle and/or the charger (15) of the vehicle.

4. System for diagnosing the state of a contactor of an electric vehicle working in a voltage range higher than the system for diagnosing, according to claims 2 or 3, wherein it comprises an additional power source (5) operatively connected to the contactor (1, 2) and to the means (3) for detecting a current.

5. System for diagnosing the state of a contactor of an electric vehicle working in a voltage range higher than the system for diagnosing, according to claim 4, wherein the controller (14) is configured for controlling the additional power source (5) switching it on/off.

6. System for diagnosing the state of a contactor of an electric vehicle working in a voltage range higher than the system for diagnosing, according to claim 3 and 4, wherein it comprises:
- two contactors (1, 2) operatively connected to the power source, a first contactor (1) associated with a positive terminal of the battery (4), a second contactor (2) associated with a negative terminal of the battery (4), the controller (14) configured to command the first contactor (1) and the second contactor (2) to open and close states,
- two optocouplers for detecting a current passing through said optocouplers being located in parallel to each of the contactors (1, 2) and each optocoupler comprising two inverted diodes

7. System for diagnosing the state of a contactor of an electric vehicle working in a voltage range higher than the system for diagnosing, according to claim 6, wherein the first contactor (1) is associated with a positive terminal of the additional power source (5) and the second contactor (2) is associated with a negative terminal of the additional power source (5).

8. System for diagnosing the state of a contactor of an electric vehicle working in a voltage range higher than the system for diagnosing, according to any preceding claim, wherein the controller (14) is configured to emit a signal when there is a discrepancy between the theoretic state and the state provided by the means (3) for detecting a current.

9. System for diagnosing the state of a contactor of an electric vehicle working in a voltage range higher than the system for diagnosing, according to any preceding claim, wherein the controller (14) is configured to send a signal to activate the means (3) for detecting a current.

10. System for diagnosing the state of a contactor of an electric vehicle working in a voltage range higher than the system for diagnosing, according to any preceding claim, wherein the means (3) for detecting a current comprise a switch (12, 13).

11. Method for diagnosing the state of a contactor of an electric vehicle working in a voltage range higher than the system for diagnosing, comprising the following steps:
- communicating a controller (14) with a contactor (1, 2) and registering in the controller (14) a theoretic open or close state of the contactor (1, 2) by changing the contactor (1, 2) state and registering in the controller (14) said state as theoretic state or by receiving a signal with the state of the contactor (1, 2) and registering it in the controller (14) as the theoretic state,
- receiving a signal in the controller (14) from a means (3) for detecting a current passing based in current flow comprising an optocoupler to know if there is current passing or not through the means, connected in parallel to the contactor (1, 2) path, andwherein the contactor (1, 2) path has a lower impedance than the means (3) for detecting a current path,
▪ if current is passing through the optocoupler (3), the signal received is that the contactor (1, 2) is open, and
▪ if current is not passing through the optocoupler (3), the signal received is that the contactor (1, 2) is closed,
- comparing in the controller (14) the theoretic state of the contactor (1, 2) with the state of the contactor (1, 2) received from the means (3) for detecting a current,
- providing a resistor (7) configured to limit the current through the optocoupler, and
**characterised in that** it comprises:
- providing a capacitor (6) such that if the contactor (1, 2) is opened and optocoupler is enabled, current flows through it until the capacitor (6) is fully charged, the capacitor (6) limiting the power dissipation on the resistor (7).

12. Method for diagnosing the state of a contactor of an electric vehicle working in a voltage range higher than the system for diagnosing, according to claim 11, wherein it comprises the additional step of changing the state of an additional power source (5) to on state to provide the voltage to the contactor (1, 2).

## Patentansprüche

1. - System zur Diagnose des Zustands eines Schützes eines Elektrofahrzeugs, das in einem Spannungsbereich arbeitet, der höher als das Diagnosesystem ist, wobei das System Folgendes umfasst:
ein Schütz (1, 2), das zwischen einem geschlossenen und einem offenen Zustand beweglich ist,
Mittel (3) zum Erfassen eines Stroms, umfassend einen Optokoppler, um festzustellen, ob Strom durch das Mittel (3) fließt oder nicht, wobei das Mittel (3) parallel zum Schützpfad (1, 2) geschaltet ist, wobei der Schützpfad (1, 2) eine niedrigere Impedanz als der Pfad des Mittels (3) aufweist, und ein Steuergerät (14), das funktionsfähig mit dem Schütz (1, 2) und den Mitteln (3) zum Erfassen eines Stroms verbunden ist,
wobei das Steuergerät (14) für Folgendes konfiguriert ist:
∘ Kommunizieren mit dem Schütz (1, 2) und Registrieren im Steuergerät (14) eines theoretischen offenen oder geschlossenen Zustands des Schützes (1, 2) durch Ändern des Zustands des Schützes (1, 2) und Registrieren dieses Zustands im Steuergerät (14) als theoretischer Zustand oder durch Empfangen eines Signals mit dem Zustand des Schützes (1, 2) und Registrieren dieses Signals im Steuergerät (14) als theoretischer Zustand,
∘ Empfangen eines Signals von den Mitteln (3) zum Erfassen eines Stroms:
▪ Wenn Strom durch den Optokoppler fließt, ist das empfangene Signal, dass der Schütz (1, 2) geöffnet ist, und
▪ Wenn kein Strom durch den Optokoppler fließt, ist das empfangene Signal, dass der Schütz (1, 2) geschlossen ist,
∘ Vergleichen des theoretischen Zustands des Schützes (1, 2) mit dem Zustand des Schützes (1, 2), der von den Mitteln (3) zum Erfassen eines Stroms empfangen wird,
einen Widerstand (7), der so konfiguriert ist, dass er den Strom durch den Optokoppler begrenzt,
das System ist **dadurch gekennzeichnet, dass** es Folgendes umfasst:
einen Kondensator (6), der so konfiguriert ist, dass beim Öffnen des Schützes (1, 2) und bei aktiviertem Optokoppler Strom durch ihn fließt, bis der Kondensator (6) vollständig geladen ist, wobei der Kondensator (6) so konfiguriert ist, dass er die Verlustleistung am Widerstand (7) begrenzt.

2. - System zur Diagnose des Zustands eines Schützes eines Elektrofahrzeugs, das in einem Spannungsbereich arbeitet, der höher als das Diagnosesystem nach Anspruch 1 ist, wobei es eine Stromquelle umfasst, die funktionsfähig mit dem Schütz (1, 2) und den Mitteln (3) zum Erfassen eines Stroms verbunden ist.

3. - System zur Diagnose des Zustands eines Schützes eines Elektrofahrzeugs, das in einem Spannungsbereich arbeitet, der höher als das Diagnosesystem nach Anspruch 2 ist, wobei die Stromquelle die Batterie (4) des Elektrofahrzeugs und/oder das Ladegerät (15) des Fahrzeugs ist.

4. - System zur Diagnose des Zustands eines Schützes eines Elektrofahrzeugs, das in einem Spannungsbereich arbeitet, der höher als das Diagnosesystem nach den Ansprüchen 2 oder 3 ist, wobei es eine zusätzliche Stromquelle (5) umfasst, die funktionsfähig mit dem Schütz (1, 2) und den Mitteln (3) zum Erfassen eines Stroms verbunden ist.

5. - System zur Diagnose des Zustands eines Schützes eines Elektrofahrzeugs, das in einem Spannungsbereich arbeitet, der höher als das Diagnosesystem nach Anspruch 4 ist, wobei das Steuergerät (14) so konfiguriert ist, dass es die zusätzliche Stromquelle (5) durch Ein-/Ausschalten steuert.

6. - System zur Diagnose des Zustands eines Schützes eines Elektrofahrzeugs, das in einem Spannungsbereich arbeitet, der höher als das Diagnosesystem nach Anspruch 3 und 4 ist, wobei es Folgendes umfasst:
zwei Schütze (1, 2), die funktionsfähig mit der Stromquelle verbunden sind, wobei ein erster Schütz (1) einem Pluspol der Batterie (4) zugeordnet ist, ein zweiter Schütz (2) einem Minuspol der Batterie (4) zugeordnet ist, wobei das Steuergerät (14) so konfiguriert ist, dass es den ersten Schütz (1) und den zweiten Schütz (2) in einen geöffneten und einen geschlossenen Zustand steuert,
zwei Optokoppler zum Erfassen eines durch die Optokoppler fließenden Stroms, die parallel zu jedem der Schütze (1, 2) angeordnet sind, wobei jeder Optokoppler zwei invertierte Dioden umfasst

7. - System zur Diagnose des Zustands eines Schützes eines Elektrofahrzeugs, das in einem Spannungsbereich arbeitet, der höher als das Diagnosesystem nach Anspruch 6 ist, wobei der erste Schütz (1) einem Pluspol der zusätzlichen Stromquelle (5) zugeordnet ist und der zweite Schütz (2) einem Minuspol der zusätzlichen Stromquelle (5) zugeordnet ist.

8. - System zur Diagnose des Zustands eines Schützes eines Elektrofahrzeugs, das in einem Spannungsbereich arbeitet, der höher als das Diagnosesystem nach einem der vorhergehenden Ansprüche ist, wobei das Steuergerät (14) so konfiguriert ist, dass es ein Signal aussendet, wenn eine Diskrepanz zwischen dem theoretischen Zustand und dem von den Mitteln (3) zum Erfassen eines Stroms bereitgestellten Zustand besteht.

9. - System zur Diagnose des Zustands eines Schützes eines Elektrofahrzeugs, das in einem Spannungsbereich arbeitet, der höher als das Diagnosesystem nach einem der vorhergehenden Ansprüche ist, wobei das Steuergerät (14) so konfiguriert ist, dass es ein Signal sendet, um die Mittel (3) zum Erfassen eines Stroms zu aktivieren.

10. - System zur Diagnose des Zustands eines Schützes eines Elektrofahrzeugs, das in einem Spannungsbereich arbeitet, der höher als das Diagnosesystem nach einem der vorhergehenden Ansprüche ist, wobei die Mittel (3) zum Erfassen eines Stroms einen Schalter (12, 13) umfassen.

11. - Verfahren zur Diagnose des Zustands eines Schützes eines Elektrofahrzeugs, das in einem Spannungsbereich arbeitet, der höher als das Diagnosesystem ist, umfassend die folgenden Schritte:
Kommunizieren eines Steuergeräts (14) mit einem Schütz (1, 2) und Registrieren im Steuergerät (14) eines theoretischen offenen oder geschlossenen Zustands des Schützes (1, 2) durch Ändern des Zustands des Schützes (1, 2) und Registrieren dieses Zustands im Steuergerät (14) als theoretischer Zustand oder durch Empfangen eines Signals mit dem Zustand des Schützes (1, 2) und Registrieren dieses Signals im Steuergerät (14) als theoretischer Zustand,
Empfangen eines Signals in dem Steuergerät (14) von einem Mittel (3) zum Erfassen eines fließenden Stroms basierend auf dem Stromfluss, das einen Optokoppler umfasst, um festzustellen, ob Strom durch das Mittel fließt oder nicht, das parallel zum Schützpfad (1, 2) geschaltet ist, undwobei der Schützpfad (1, 2) eine niedrigere Impedanz als das Mittel (3) zum Erfassen eines Strompfads aufweist,
▪ Wenn Strom durch den Optokoppler (3) fließt, wird das Signal empfangen, dass der Schütz (1, 2) geöffnet ist, und
▪ Wenn kein Strom durch den Optokoppler (3) fließt, wird das Signal empfangen, dass der Schütz (1, 2) geschlossen ist, Vergleichen im Steuergerät (14) des theoretischen Zustands des Schützes (1, 2) mit dem Zustand des Schützes (1, 2), der von den Mitteln (3) zum Erfassen eines Stroms empfangen wird,
Bereitstellen eines Widerstands (7), der so konfiguriert ist, dass er den Strom durch den Optokoppler begrenzt, und
**dadurch gekennzeichnet, dass** es Folgendes umfasst:
Bereitstellen eines Kondensators (6), sodass beim Öffnen des Schützes (1, 2) und bei aktiviertem Optokoppler Strom durch ihn fließt, bis der Kondensator (6) vollständig geladen ist, wobei der Kondensator (6) die Verlustleistung am Widerstand (7) begrenzt.

12. - Verfahren zur Diagnose des Zustands eines Schützes eines Elektrofahrzeugs, das in einem Spannungsbereich arbeitet, der höher als das Diagnosesystem nach Anspruch 11 ist, wobei es den zusätzlichen Schritt umfasst, den Zustand einer zusätzlichen Stromquelle (5) in den Ein-Zustand zu ändern, um die Spannung für den Schütz (1, 2) bereitzustellen.

## Revendications

1. - Système de diagnostic de l'état d'un contacteur de véhicule électrique travaillant dans une gamme de tension supérieure au système de diagnostic, le système comprenant :
- un contacteur (1, 2) mobile entre un état fermé et un état ouvert,
- un moyen (3) de détection de courant comprenant un optocoupleur pour savoir si un courant passe ou non à travers le moyen (3), le moyen (3) étant connecté en parallèle au trajet du contacteur (1, 2), dans lequel le trajet du contacteur (1, 2) a une impédance inférieure au trajet du moyen (3), et
- un dispositif de commande (14) connecté de manière opérationnelle au contacteur (1, 2) et au moyen (3) de détection d'un courant, le dispositif de commande (14) étant configuré pour :
∘ communiquer avec le contacteur (1, 2) et enregistrer dans le dispositif de commande (14) un état théorique ouvert ou fermé du contacteur (1, 2) en modifiant l'état du contacteur (1, 2) et pour enregistrer dans le dispositif de commande (14) ledit état comme état théorique ou en recevant un signal avec l'état du contacteur (1, 2) et en l'enregistrant dans le dispositif de commande (14) comme état théorique,
o recevoir un signal provenant du moyen (3) de détection d'un courant :
▪ si le courant traverse l'optocoupleur, le signal reçu est que le contacteur (1, 2) est ouvert, et
▪ si le courant ne traverse pas l'optocoupleur, le signal reçu est que le contacteur (1, 2) est fermé,
∘ comparer l'état théorique du contacteur (1, 2) avec l'état du contacteur (1, 2) reçu du moyen (3) de détection d'un courant,
- une résistance (7) configurée pour limiter le courant à travers l'optocoupleur,
le système étant **caractérisé en ce qu'**il comprend :
- un condensateur (6) configuré de telle sorte que si le contacteur (1, 2) est ouvert et l'optocoupleur est activé, le courant circule à travers jusqu'à ce que le condensateur (6) soit complètement chargé, le condensateur (6) étant configuré pour limiter la dissipation de puissance sur la résistance (7).

2. - Système de diagnostic de l'état d'un contacteur de véhicule électrique travaillant dans une gamme de tension supérieure au système de diagnostic, selon la revendication 1, dans lequel il comprend une source d'alimentation connectée de manière opérationnelle au contacteur (1, 2) et au moyen (3) de détection d'un courant.

3. - Système de diagnostic de l'état d'un contacteur de véhicule électrique travaillant dans une gamme de tension supérieure au système de diagnostic, selon la revendication 2, dans lequel la source d'alimentation est la batterie (4) du véhicule électrique et/ou le chargeur (15) du véhicule.

4. - Système de diagnostic de l'état d'un contacteur de véhicule électrique travaillant dans une gamme de tension supérieure au système de diagnostic, selon la revendication 2 ou 3, dans lequel il comprend une source d'alimentation additionnelle (5) connectée de manière opérationnelle au contacteur (1, 2) et au moyen (3) de détection d'un courant.

5. - Système de diagnostic de l'état d'un contacteur de véhicule électrique travaillant dans une gamme de tension supérieure au système de diagnostic, selon la revendication 4, dans lequel le dispositif de commande (14) est configuré pour commander une source d'alimentation additionnelle (5) en la mettant en et hors tension.

6. - Système de diagnostic de l'état d'un contacteur de véhicule électrique travaillant dans une gamme de tension supérieure au système de diagnostic, selon la revendication 3 ou 4, dans lequel il comprend :
- deux contacteurs (1, 2) connectés de manière opérationnelle à la source d'alimentation, un premier contacteur (1) étant associé à une borne positive de la batterie (4), un second contacteur (2) étant associé à une borne négative de la batterie (4), le dispositif de commande (14) étant configuré pour commander le premier contacteur (1) et le deuxième contacteur (2) à être dans des états ouverts et fermés,
- deux optocoupleurs de détection d'un courant traversant lesdits optocoupleurs étant situés en parallèle de chacun des contacteurs (1, 2) et chaque optocoupleur comprenant deux diodes inversées

7. - Système de diagnostic de l'état d'un contacteur de véhicule électrique travaillant dans une gamme de tension supérieure au système de diagnostic, selon la revendication 6, dans lequel le premier contacteur (1) est associé à une borne positive de la source d'alimentation additionnelle (5) et le second contacteur (2) est associé à une borne négative de la source d'alimentation additionnelle (5).

8. - Système de diagnostic de l'état d'un contacteur de véhicule électrique travaillant dans une gamme de tension supérieure au système de diagnostic, selon une quelconque revendication précédente, dans lequel le dispositif de commande (14) est configuré pour émettre un signal lorsqu'il existe une divergence entre l'état théorique et l'état fourni par le moyen (3) de détection d'un courant.

9. - Système de diagnostic de l'état d'un contacteur de véhicule électrique travaillant dans une gamme de tension supérieure au système de diagnostic, selon une quelconque revendication précédente, dans lequel le dispositif de commande (14) est configuré pour envoyer un signal pour activer le moyen (3) de détection d'un courant.

10. - Système de diagnostic de l'état d'un contacteur de véhicule électrique travaillant dans une gamme de tension supérieure au système de diagnostic, selon l'une quelconque des revendications précédentes, dans lequel le moyen (3) de détection d'un courant comprend un commutateur (12, 13).

11. - Procédé de diagnostic de l'état d'un contacteur de véhicule électrique travaillant dans une gamme de tension supérieure au système de diagnostic, comprenant les étapes suivantes :
- la communication d'un dispositif de commande (14) et un contacteur (1, 2) et l'enregistrement dans le dispositif de commande (14) d'un état théorique ouvert ou fermé du contacteur (1, 2) en modifiant l'état du contacteur (1, 2) et en enregistrant dans le dispositif de commande (14) ledit état comme état théorique ou en recevant un signal avec l'état du contacteur (1, 2) et en l'enregistrant dans le dispositif de commande (14) comme état théorique,
- la réception d'un signal dans le dispositif de commande (14) d'un moyen (3) de détection de courant passant sur la base d'une circulation de courant comprenant un optocoupleur pour savoir si un courant passe ou non à travers le moyen, connecté en parallèle au trajet du contacteur (1, 2), et dans lequel le trajet du contacteur (1, 2) a une impédance inférieure au moyen (3) de détection d'un trajet de courant,
• si le courant traverse l'optocoupleur (3), le signal reçu est que le contacteur (1, 2) est ouvert, et
▪si le courant ne traverse pas l'optocoupleur (3), le signal reçu est que le contacteur (1, 2) est fermé,
- la comparaison dans le dispositif de commande (14) de l'état théorique du contacteur (1, 2) avec l'état du contacteur (1, 2) reçu du moyen (3) de détection d'un courant,
- la fourniture d'une résistance (7) configurée pour limiter le courant à travers l'optocoupleur, et
**caractérisé en ce qu'**il comprend :
- la fourniture d'un condensateur (6) de telle sorte que si le contacteur (1, 2) est ouvert et l'optocoupleur est activé, le courant circule à travers jusqu'à ce que le condensateur (6) soit complètement chargé, le condensateur (6) limitant la dissipation de puissance sur la résistance (7).

12. - Procédé de diagnostic de l'état d'un contacteur de véhicule électrique travaillant dans une gamme de tension supérieure au système de diagnostic, selon la revendication 11, dans lequel il comprend l'étape additionnelle de modification de l'état d'une source d'alimentation additionnelle (5) à un état pour fournir la tension du contacteur (1, 2).
